(19) Europäisches Patentamt
European Patent Office
Office européen des brevets

(11) **EP 4 407 334 A1**

(12) **EUROPÄISCHE PATENTANMELDUNG**

(43) Veröffentlichungstag:
**31.07.2024  Patentblatt 2024/31**

(21) Anmeldenummer: 23153270.6

(22) Anmeldetag: **25.01.2023**

(51) Internationale Patentklassifikation (IPC):
*G01R 33/24* (2006.01)

(52) Gemeinsame Patentklassifikation (CPC):
**G01R 33/243**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Siemens Healthineers AG**
**91301 Forchheim (DE)**

(72) Erfinder: **Popescu, Stefan**
**91056 Erlangen (DE)**

(74) Vertreter: **Siemens Healthineers**
**Patent Attorneys**
**Postfach 22 16 34**
**80506 München (DE)**

(54) **VERFAHREN UND MESSVORRICHTUNG ZUR VERMESSUNG EINES MAGNETFELDS IN EINEM SICHTFELD EINER MAGNETRESONANZEINRICHTUNG**

(57) Verfahren zur Vermessung eines Magnetfelds in einem Sichtfeld (4, 5) einer Magnetresonanzeinrichtung (2), aufweisend folgende Schritte:
- Bereitstellen einer wenigstens einen Magnetfeldsensor (15) umfassenden Messvorrichtung (12, 12'),
- Messen von das Magnetfeld beschreibenden Sensordaten an mehreren Messpunkten (10) auf einer wenigstens einen Teil des Sichtfelds (4, 5) umschließenden Messoberfläche (11), und
- Ermitteln einer Magnetfeldinformation, die das Magnetfeld wenigstens innerhalb des Sichtfelds (4, 5) dreidimensional modelliert, aus den Sensordaten,
dadurch gekennzeichnet, dass die Messpunkte (10) in einem gleichverteilten Abtastmuster zur gleichmäßigen Abtastung der gesamten Messoberfläche (11) gewählt werden.

**FIG 2**

**Beschreibung**

Die Erfindung betrifft ein Verfahren zur Vermessung eines Magnetfelds in einem Sichtfeld einer Magnetresonanzeinrichtung, aufweisend folgende Schritte:

- Bereitstellen einer wenigstens einen Magnetfeldsensor umfassenden Messvorrichtung,
- Messen von das Magnetfeld beschreibenden Sensordaten an mehreren Messpunkten auf einer wenigstens einen Teil des Sichtfelds umschließenden Messoberfläche, und
- Ermitteln einer Magnetfeldinformation, die das Magnetfeld wenigstens innerhalb des Sichtfelds dreidimensional modelliert, aus den Sensordaten.

Daneben betrifft die Erfindung eine Messvorrichtung.

Die Magnetresonanzbildgebung ist ein inzwischen etabliertes Hilfsmittel in der medizinischen Diagnostik. Sie beruht darauf, Kernspins innerhalb eines Patienten, die mittels eines Hauptmagnetfeldes (statisches Magnetfeld beziehungsweise B0-Feld) einer Magnetresonanzeinrichtung in eine Vorzugsrichtung ausgerichtet sind, mit Hochfrequenzpulsen anzuregen und den Zerfall der Anregung zu vermessen, wofür eine geeignete Hochfrequenzspulenanordnung verwendet werden kann. Zur Ortskodierung werden Gradientenfelder einer Gradientenspulenanordnung eingesetzt.

Mit der Komplexität der durch Magnetresonanz untersuchten klinischen Fragestellungen steigt auch der Wunsch nach einer hohen beziehungsweise steigenden Bildqualität aufgenommener Magnetresonanzdaten. Eine wesentliche Voraussetzung für eine hochqualitative Messung in der Magnetresonanzbildgebung, um beispielsweise möglichst artefaktfreie anatomische Bilder zu rekonstruieren, ist die Erfüllung hoher Anforderungen an die Qualität der Magnetfelder, die zur Messung der Magnetresonanzdaten eingesetzt werden. Beispielsweise muss das Hauptmagnetfeld hinreichend stark und dabei äußerst homogen im Messvolumen, welches üblicherweise das Sichtfeld (Field of View - FoV) genannt wird, sein. Um geometrisch und anatomisch möglichst akkurate Magnetresonanzdaten zu erhalten, müssen die Gradientenfelder, die insbesondere zur Kodierung der räumlichen Koordinaten eingesetzt werden, monoton und idealerweise sogar nahtlos linear über das Sichtfeld sein. Beispielhafte Anforderungen an die Homogenität des Hauptmagnetfeldes sind eine kleinere Abweichung als 20 ppm Peak-zu-Peak oder weniger als 3 ppm Root Mean Square (RMS). Unter Anwendung klassischer Methoden, insbesondere klassischer Magnetresonanzsequenzen und Aufnahmeprotokolle, ist eine Aufnahme hinreichend genauer Magnetresonanzdaten nur in Sichtfeldern möglich, die solche Anforderungen erfüllen.

Aufgrund der physikalischen und technischen Bedingungen haben derartige Anforderungen jedoch hohe Kosten für die benötigte Ausrüstung zur Magnetresonanzbildgebung zur Folge, insbesondere bezüglich des Materials, der Herstellung und der Betriebskosten von Hochfeld-Magneten. Um die Kosten, die mit der hohen magnetischen Feldhomogenität und der Linearität der Gradientenfelder aufkommen, zu reduzieren, wird das Sichtfeld in allen drei räumlichen Dimensionen beschränkt. Allerdings hat eine solche Einschränkung des Sichtfelds klinische Nachteile zur Folge, beispielsweise abgeschnittene Magnetresonanzbilder bei fettleibigen Patienten oder längere Scanzeiten zur Abdeckung größerer Körperbereiche, beispielsweise für Ganzkörper-Krebsscans. Hier könnten Verbesserungen dadurch erreicht werden, dass nicht ideale Magnetfeldverteilungen toleriert würden. Beispielsweise wurde im Stand der Technik bereits vorgeschlagen, solche nicht idealen Magnetfelder a priori zu kalibrieren und zu modellieren, um auf der Basis einer entsprechenden Magnetfeldinformation Bildartefakte zu reduzieren und/oder zu korrigieren, indem nicht-standardisierte Bildrekonstruktionsverfahren eingesetzt werden.

Eine solche Vermessung von Magnetfeldern in Magnetresonanzeinrichtungen ist auch allgemein nützlich und bekannt, wenn beispielsweise Shim-Maßnahmen eingestellt werden sollen und/oder elektronische, allgemeine Korrekturmaßnahmen, auch in einem kleineren Sichtfeld, vorbereitet werden sollen.

Allgemein kann gesagt werden, dass die möglichst genaue Vermessung des Magnetfelds in einer Magnetresonanzeinrichtung eine für viele Anwendungsgebiete wichtige Aufgabenstellung im Rahmen der Magnetresonanzbildgebung darstellt.

Im Stand der Technik wurde zur Vermessung von Magnetfeldern in einer Magnetresonanzeinrichtung bereits eine Vielzahl unterschiedlicher Messvorrichtungen vorgeschlagen, die häufig auch als Magnetfeldkamera oder kurz Feldkamera bezeichnet werden. Eine solche Messvorrichtung tastet das Magnetfeld an diskreten, räumlich verteilten Messpunkten auf einer Messoberfläche, die das Sichtfeld umschließt, ab. Bei dieser Messoberfläche handelt es sich häufig um eine Kugeloberfläche einer sogenannten virtuellen Kalibrierungskugel. Das Zentrum, um das sich die Messoberfläche erstreckt, fällt mit dem Isozentrum des Sichtfelds zusammen. Die gemessenen Magnetfeldwerte, also die Sensordaten, werden dann häufig genutzt, um ein mathematisches Magnetfeldmodell zu kalibrieren, mithin eine Magnetfeldinformation zu bestimmen, die das Magnetfeld wenigstens innerhalb des Sichtfelds dreidimensional modelliert. Bei einer Kugeloberfläche als Messoberfläche, aber auch anderweitig geformten Messoberflächen, findet üblicherweise eine Magnetfeldzerlegung unter Verwendung von harmonischen Funktionen, insbesondere den Solid Harmonics, die häufig auch als Solid Spherical Harmonics (SSH) bezeichnet werden, statt.

Eine bekannte Messvorrichtung, also Feldkamera, ist beispielsweise das Modell MFC2046, erhältlich von Metrolab Technology SA, 1228 Plan-les-Quates, Genf, Schweiz. Dabei wird ein halbscheibenförmiger Sensorträger, an dessen halbkreisförmiger Außenberandung äquidistant Magnetfeldsensoren angeordnet sind, verwendet, beispielsweise 32 Magnetfeldsensoren. Derartige Magnetfeldsensoren werden auch im Allgemeinen häufig als Magnetometer oder im Englischen auch als "Magnetic Field Probes" bezeichnet. Der Sensorträger wird durch einen Sensorhalter getragen, mittels dessen der Sensorträger um eine Längsachse gedreht werden kann. An einer vorgegebenen Anzahl, beispielsweise 30, festgelegten/vordefinierten Winkelpositionen, die beispielsweise jeweils um 12 Grad getrennt sein können, wird durch die beispielsweise 32 Magnetfeldsensoren die magnetische Feldstärke vermessen. Auf diese Weise entstehen bei 30 vordefinierten Messpositionen und 32 Magnetfeldsensoren 960 Messpunkte auf einer Kugeloberfläche. Unter Verwendung der Sensordaten der Magnetfeldsensoren ist es nun möglich, ein Magnetfeldmodell an diese Sensordaten anzufitten, welches Solid Spherical Harmonics als Basisfunktionen verwendet. Anders gesagt können zur Ermittlung der Magnetfeldinformation Koeffizienten einer Entwicklung nach harmonischen Funktionen, insbesondere nach Solid Spherical Harmonics, ermittelt werden.

Ein hauptsächlicher Vorteil dieser oder vergleichbarer Lösungen besteht darin, dass die Messvorrichtung kostengünstig und einfach realisiert und verwendet werden kann, nachdem wenige Magnetfeldsensoren ausreichend sind, um eine große Anzahl an Messpunkten einer dreidimensionalen Magnetfeldverteilung zu vermessen. Ein Nachteil ist, dass skalare Magnetfeldsensoren verwendet werden, mithin lediglich die Magnitude des Magnetfelds modelliert werden kann. Dabei wird die implizite Annahme verwendet, dass innerhalb des Sichtfelds der Magnetresonanzeinrichtung die magnetischen Feldvektoren entlang der Längsrichtung (z-Richtung) ausgerichtet sind. Ein weiterer Nachteil ergibt sich dadurch, dass die räumliche Verteilung der Messpunkte auf der Messoberfläche, hier Kugeloberfläche, stark ungleichmäßig ist. Konkret tritt eine hohe Dichte der Messpunkte nahe des Nordpols und des Südpols der Kugeloberfläche auf, während die Abtastdichte zum Äquator hin abnimmt.

US 10 018 690 B2 betrifft ein Phantom zur Verwendung in einer Magnetresonanzeinrichtung, welches einen Satz resonierender Volumina auf einem Grundkörper sphärischer oder ellipsoider Form umfasst. Das Phantom wird im Sichtfeld positioniert, wonach mittels einer dreidimensionalen spektroskopischen Magnetresonanzmessung das Magnetfeld vermessen werden kann. Auf diese Weise soll die Magnetresonanzeinrichtung selbst zur Vermessung des Magnetfelds ihres Hauptmagneten eingesetzt werden.

In einem anderen Ansatz wurde auch vorgeschlagen, eine Messeinrichtung mit einem einzigen Magnetfeldsensor zu verwenden, bevorzugt einem Vektor-Magnetometer, welcher mittels eines Roboterarms an unterschiedlichen Messpunkten auf einer Messoberfläche positioniert werden kann. Auf diese Weise können die Kosten für Magnetfeldsensoren weiter reduziert werden, während gleichzeitig eine größere Flexibilität zur Herstellung eines bestimmten Abtastmusters beziehungsweise einer dreidimensionalen Abtasttrajektorie gegeben ist. In diesem Zusammenhang offenbart US 5 313 164 A eine Vorrichtung zum Kartieren eines statischen Magnetfeldes, wobei ein Magnetfeldsensor, der selbst mit Magnetresonanz arbeitet, sukzessive an verschiedene diskreten Messpunkten entlang eines helisphärischen oder heliellipsoidischen Pfades positioniert wird, um das statische Magnetfeld zu vermessen und Shimeinrichtungen zu positionieren beziehungsweise zu parametrieren. Ein solcher helisphärischer oder heliellipsoidischer Abtastpfad soll für die Kalibrierung von hochgradig homogenen Magnetfeldern besonders geeignet sein, da homogene Magnetfelder häufig kugelförmig oder ellipsoidförmig sind. Solche Ansätze für Messvorrichtungen haben jedoch den Nachteil, dass eine äußerst lange Messzeit im Vergleich zu einer Feldkamera benötigt wird, die eine Mehrzahl von Magnetfeldsensoren verwendet.

US 2022/0252685 A1 offenbart eine Magnetresonanzeinrichtung mit einer Feldkamera zur Bestimmung von Magnetfeldinformationen in einem Sichtfeld. Die Feldkamera umfasst dabei mehrere Magnetfeldsensoren, die an Messpositionen, die das Sichtfeld einschließen, positioniert sind. Dabei sind die Magnetfeldsensoren als Vektor-Magnetometer ausgebildet, messen mithin das Magnetfeld dreidimensional, also in Betrag und Richtung. Hierbei soll die räumliche Verteilung eines zeitlich variierenden Vektor-Magnetfelds kalibriert werden.

Ein hauptsächliches Problem der genannten Ansätze des Standes der Technik ist, dass diese gezielt für äußerst homogene Magnetfelder entwickelt und optimiert sind, beispielsweise für das Hauptmagnetfeld in einem herkömmlichen Sichtfeld einer Magnetfeldresonanzeinrichtung. Allerdings besteht, insbesondere bei neueren Ansätzen, in der Magnetresonanzbildgebung oft ein Bedürfnis, magnetische Felder hoher Inhomogenität zu kalibrieren und zu modellieren, beispielsweise magnetische Feldgradienten, die für die räumliche Kodierung der Magnetresonanzsignale eingesetzt werden. Insbesondere werden Gradientenfelder, wie im Stand der Technik bekannt ist, stark nicht linear, je weiter man sich vom Isozentrum entfernt und der Peripherie des Sichtfelds nähert. Dies kann jedoch auch für das Hauptmagnetfeld (B0-Feld) gesagt werden. Insbesondere treten außerhalb von Standard-Sichtfeldern auch Anforderungen verletzende Abweichungen der Magnetfelder auf.

Auf der anderen Seite wurden jedoch im Stand der Technik auch bereits Vorgehensweisen vorgeschlagen, um das Sichtfeld in Bereiche zu erweitern, in denen die Anforderungen für die Standard-Messmethoden nicht mehr erfüllt sind. Beispielsweise wurde in US 10 768 257 B2 vorgeschlagen, erst Magnetresonanzdaten aus einem ersten Aufnahmebereich innerhalb eines Homogenitätsvolumens einer Magnetresonanzeinrichtung und zweite Magnetresonanzdaten in einem zweiten Aufnahmebereich außerhalb des Homogenitätsvolumens aufzunehmen. Die ersten und die zweiten Magnetresonanzdaten werden getrennt zu Bilddaten rekonstruiert und kombiniert, um ein kombiniertes Magnetresonanzbild zu erzeugen, welches einen sich in den ersten Aufnahmebereich und dem zweiten Aufnahmebereich erstreckenden Bildbereich abdeckt. Konkret wird zur Berücksichtigung der Feldinhomogenitäten im zweiten Aufnahmebereich dabei vorgeschlagen, ein signalmodellbasiertes Bildrekonstruktionsverfahren einzusetzen und insbesondere Regridding-Methoden zu verwenden.

Der Erfindung liegt daher die Aufgabe zugrunde, eine Möglichkeit zur Vermessung von Magnetfeldern anzugeben, die auch für hochgradig inhomogene Magnetfelder die Bestimmung einer hochqualitativen Magnetfeldinformation erlaubt.

Diese Aufgabe wird erfindungsgemäß gelöst durch ein Verfahren und eine Messvorrichtung mit den Merkmalen der unabhängigen Ansprüche. Vorteilhafte Ausgestaltungen ergeben sich aus den abhängigen Ansprüchen.

Bei einem Verfahren der eingangs genannten Art ist erfindungsgemäß vorgesehen, dass die Messpunkte in einem gleichverteilten Abtastmuster zur gleichmäßigen Abtastung der gesamten Messoberfläche gewählt werden.

Dabei sei an dieser Stelle bereits angemerkt, dass es sich auch im Rahmen der vorliegenden Erfindung bei der Messoberfläche bevorzugt um eine Kugeloberfläche handelt, wobei zur Ermittlung der Magnetfeldinformation Koeffizienten einer Entwicklung nach harmonischen Funktionen, insbesondere nach Solid Harmonics (teilweise auch als Solid Spherical Harmonics, SSH, bezeichnet), ermittelt werden. Grundsätzlich sind jedoch auch andere Messoberflächen denkbar, beispielsweise Ellipsoide oder dergleichen, wofür dann dasselbe Modell, insbesondere im Fall der Solid Harmonics, oder auch ein angepasstes mathematisches Magnetfeldmodell herangezogen werden können. Dabei wird die Zahl der Messpunkte zweckmäßig derart gewählt, dass der Fit nicht mehrdeutig bestimmt ist, sich mithin eine eindeutige Lösung zur Modellierung ergibt. Beispielsweise kann die Zahl der Messpunkte größer oder gleich der Zahl der zu bestimmenden Koeffizienten in dem Magnetfeldmodell gewählt werden. Die Solid Harmonics sind als die Lösungen der Laplace-Gleichung zu verstehen. Diese eignen sich besonders, da das Magnetfeld ja ein harmonisches Feld ist.

Ferner sei noch darauf hingewiesen, dass das von der Messoberfläche eingeschlossene Volumen das Sichtfeld nicht vollständig umfassen muss. Vielmehr ist es auch denkbar, beispielsweise eine innerhalb des Sichtfeldes liegende Messoberfläche zu verwenden, da sich insbesondere bei der Verwendung einer Entwicklung nach harmonischen Funktionen gezeigt hat, dass auch eine hochqualitative Extrapolation nach außen möglich ist. Allerdings erlaubt eine ein größeres Volumen umspannende Messoberfläche eine genauere Vermessung der relevanten Harmonischen, do dass die Messoberfläche meist das gesamte Sichtfeld möglichst eng umschließend gewählt wird.

Wird eine Zerlegung in harmonische Funktionen, insbesondere Solid Harmonics, als Magnetfeldmodell herangezogen, werden bei der Kalibrierung und Modellierung der vermessenen dreidimensionalen Feldverteilung die Koeffizienten der Linearzerlegung des Magnetfelds in eine gewichtete Summe einer bestimmten Anzahl von harmonischen Funktionen durch den Fit ermittelt. Die Vollständigkeit des Magnetfeldmodells impliziert dabei, dass die Zerlegung für eine hinreichende Anzahl von Basisfunktionen, also harmonische Funktionen, zum exakten Ergebnis konvergiert.

Bei herkömmlichen Vorgehensweisen besteht nun der Nachteil, dass diese optimiert sind, a priori bekannte Feldinhomogenitäten abzubilden, so dass eine geringe Anzahl an Basisfunktionen, die diese erwarteten Eigenschaften widerspiegeln, verwendet wurde, insbesondere auch gezielt versucht wurde, bestimmte Basisfunktionen, insbesondere Solid Harmonics und/oder Kugelfunktionen, "anzuzielen". Im Rahmen von Untersuchungen haben die Erfinder nun festgestellt, dass die Inhomogenität sowohl des Hauptmagnetfelds als auch der Gradientenfelder außerhalb des Standard-Sichtfelds dramatisch zunimmt, was zwei Folgen hat.

Zum einen treten eine deutlich höhere Anzahl und deutlich höhere Ordnungen von harmonischen Funktionen mit höherer Gewichtung auf, die detektiert und modelliert werden müssen. Das bedeutet aber, dass eine deutlich höhere Anzahl an Messpunkten erforderlich ist. Die zweite Konsequenz ist, dass die Abtastmuster des Standes der Technik, die für hochgradig homogene Feldverteilungen ermittelt wurden und/oder auf bestimmte Feldharmonische abzielten, ungeeignet werden. Insbesondere liefern diese Abtastmuster des Standes der Technik die benötigte höhere Dichte von Messpunkten nicht dort, wo sie auch benötigt wird.

Durch Simulation und Versuche wurde nun festgestellt, dass, um beispielsweise Gradientenfelder mit hinreichender Genauigkeit zu kalibrieren und zu modellieren, eine hohe Zahl von Koeffizienten im Magnetfeldmodell erforderlich ist. In einem Beispielfall werden 64 Koeffizienten für jede kartesische Gradientenrichtung und für jede Gradientenachse benötigt, wenn die Genauigkeit des Magnetfeldmodells weniger als 0,5% sein soll über eine Standard-Ausdehnung des Sichtfelds von beispielsweise 50 cm Durchmesser (kugelförmig). Werden lediglich 16 Koeffizienten mit 16 Magnetfeldsensoren verwendet, steigt der Vorhersagefehler für das Magnetfeld bereits über 5%. Soll nun das dreidimensionale Gradientenfeld über ein erweitertes Sichtfeld von 70 cm Durchmesser (kugelförmig) gemessen werden, steigt die Zahl der Koeffizienten deutlich über 64. Mit nur 16 Koeffizienten/Magnetfeldsensoren steigt der Vorhersagefehler sogar über 20%. Dabei sei angemerkt, dass, um sehr sensitive Magnetresonanzkontraste, beispielsweise in der Magnetresonanzspektroskopie, aufzulösen, die Genauigkeit des Magnetfeldmodells für die Gradientenfelder im Bereich von ppm liegen sollte.

Zusammenfassend erfordert eine akkurate Kalibrierung und Modellierung solcher inhomogener Magnetfelder eine höhere Anzahl an Modellkoeffizienten, also insbesondere einen höheren Grad und eine höhere Ordnung von harmonischen Funktionen, um das Magnetfeld zu modellieren, was eine höhere Anzahl an Messpunkten und gegebenenfalls eine höhere Anzahl von Magnetfeldsensoren zur Folge hat.

Hierzu kommt jedoch noch das Problem, dass bislang verwendete Abtastmuster diesbezüglich ungeeignet sind. Betrachtet man das Beispiel der Solid Harmonics, werden diese meist mit den Indizes l (Grad) und m (Ordnung) nummeriert, wobei unterschiedliche Grade und Ordnungen unterschiedliche Feldmuster auf der Messoberfläche, hier der Kugeloberfläche, zur Folge haben. Beispielsweise können für eine Ordnung von Null so genannte zonale Harmonische auftreten, welche sich durch ein Abwechseln von Maxima und Minima entlang der Längenrichtung auf der Kugeloberfläche auszeichnen. Sektorale Harmonische, die für m = +/- l auftreten können, zeichnen sich dadurch aus, dass sich in der Feldverteilung auf der Kugeloberfläche Maxima und Minima entlang der Breitenrichtung abwechseln. Kombinationen aus zonalen und sektoralen Verteilungen werden tesserale Muster genannt, bei denen in beiden Richtungen (Längenrichtung und Breitenrichtung der Kugeloberfläche) Wechsel von Minima und Maxima auftreten können.

Aufgrund dieser Untersuchungen und Schlussfolgerungen schlägt die vorliegende Erfindung vor, ein gleich verteiltes Abtastmuster zu verwenden, indem eine bidirektional gleichförmige Verteilung von Messpunkten auf der Messoberfläche gewählt wird. Auf diese Weise können beliebige Muster, insbesondere auch tesserale Muster, mit hinreichender Genauigkeit vermessen werden.

Insgesamt erlaubt eine Gleichverteilung der Messpunkte auf der Messoberfläche mithin die hinreichend genaue Vermessung von beliebig inhomogenen Feldverteilungen, da alle Arten von auftretenden Harmonischen mit gleicher Genauigkeit detektiert und somit auch modelliert werden können. Auf diese Weise können nicht nur Randbereiche von Nenn-Sichtfeldern, insbesondere auch im Hinblick auf Gradientenfelder, verbessert vermessen und modelliert werden, sondern es kann auch außerhalb des Nenn-Sichtfeldes einer Magnetresonanzeinrichtung eine Kartierung von Magnetfeldern erfolgen, beispielsweise für Verfahren wie das in US 10 768 257 B2 beschriebene.

Allgemein kann gesagt werden, dass das Sichtfeld größer als ein Nenn-Sichtfeld der Magnetresonanzeinrichtung und/oder mit einem Durchmesser größer als 40 cm, insbesondere im Bereich von 50 bis 70 cm, gewählt werden kann. Nenn-Sichtfelder von Magnetresonanzeinrichtungen, die beispielsweise sphärisch sein können, beziehen sich üblicherweise auf den Bereich, in den die gesetzten Anforderungen an die Homogenität erfüllt sind. Gerade für Ansätze, in denen ein erweitertes Sichtfeld genutzt werden soll, kann über dieses Nenn-Sichtfeld hinausgegangen werden. Das entsprechende erweiterte Sichtfeld kann mit herkömmlichen Methoden nur sehr ungenau kalibriert und/oder modelliert werden, da diese Methoden auf die dort vorkommenden Inhomogenitäten nicht eingerichtet sind. Mit der erfindungsgemäß vorgesehenen Gleichverteilung der Messpunkte über die Messoberfläche, insbesondere Kugeloberfläche, ist eine hinreichend genaue Vermessung mit vertretbarem Aufwand jedoch möglich.

Hierbei kann im Übrigen die Messoberfläche der Sichtfeldoberfläche entsprechen und/oder das Sichtfeld vollständig einschließen. Gerade im Fall sphärischer, also kugelförmiger, Sichtfelder ist es besonderes zweckmäßig, die Sichtfeldoberfläche als Messoberfläche, die dann eine Kugeloberfläche ist, heranzuziehen. In sonstigen Fällen ist es am zweckmäßigsten, das Sichtfeld möglichst eng einzuschließen. Denkbar ist es aber, wie oben dargelegt, auch, die Messoberfläche innerhalb des Sichtfelds zu definieren.

Der wenigstens eine Magnetfeldsensor kann den Betrag des Magnetfeldes und/oder eine Richtung des Magnetfeldes an den jeweiligen Messpunkten vermessen. Dabei ist es besonders vorteilhaft, insbesondere bei Anwendungen am Rand eines Nenn-Sichtfelds oder für ein gegenüber dem Nenn-Sichtfeld erweitertes Sichtfeld, auch die Richtung des Magnetfeldes zu vermessen, um auch diesbezüglich eine Modellierung zu erlauben.

Insbesondere kann bei Inhomogenitäten nicht immer davon ausgegangen werden, dass sich das Magnetfeld in der Sollrichtung des Hauptmagnetfelds orientiert. Diese Sollrichtung ist üblicherweise die Längsrichtung einer zylindrischen Patientenaufnahme der Magnetresonanzeinrichtung, die auch als z-Richtung der Magnetresonanzeinrichtung bezeichnet wird.

Als der wenigstens eine Magnetfeldsensor kann eine Messanordnung aus einem Messphantom, insbesondere umfassend eine MRaktive Substanz, und einer Messspule oder ein Hall-Sensor verwendet werden. Bei derartigen, auch Feldproben genannten Messanordnungen spricht man im Englischen häufig von "Magnetic Field Probes". Sie messen üblicherweise skalar, also den Betrag des Magnetfeldes. Hall-Sensoren können demgegenüber als Vektor-Magnetometer realisiert werden und auch die Richtung des Magnetfelds vermessen. Hall-Sensoren können inzwischen sehr kleinbauend und kostengünstig auf Halbleiterbasis, insbesondere als Chip, bereitgestellt werden.

Wie bereits erwähnt, kann das Magnetfeld ein Hauptmagnetfeld eines Hauptmagneten der Magnetresonanzeinrichtung und/oder wenigstens ein Gradientenfeld einer Gradientenspulenanordnung der Magnetresonanzeinrichtung umfassen.

Zweckmäßigerweise können die Messpunkte auf der als Kugeloberfläche ausgebildeten Messoberfläche nach einem Fibonacci-Kugel-Algorithmus als Fibonacci-Gitter bestimmt werden. Während im Stand der Technik bereits verschiedene Möglichkeiten vorgeschlagen worden sind, Messpunkte auf der Oberfläche einer Kugel so gleichmäßig wie möglich zu verteilen, stellt ein Mappen des Fibonacci-Gitters auf die Oberfläche der Kugel eine äußerst schnelle und effektive Ermittlungsmethode dar, um dieses Ziel zu erreichen. Diesbezüglich wurden auch bereits Varianten/Verbesserungen vorgeschlagen, um das Abstandsmaß der hierdurch ermittelten Messpunkte zueinander noch weiter zu optimieren und zu vergleichmäßigen. Ein Pseudocode eines bekannten Fibonacci-Algorithmus kann beispielsweise für N Messpunkte folgendermaßen lauten:

```
phi = (3-sqrt(5))* pi;

X = zeros(1,N); Y=X; Z=X;

for i=1 to N-1

    y = 1 - 2*i/(N-1);
    yradius = sqrt(1-y^2);
    theta = phi * i;
    X(i) = yradius * cos(theta);
    Y(i) = y;
    Z(i) = yradius * sin(theta);

end
```

In konkreter Ausgestaltung der Erfindung kann vorgesehen sein, dass die Messvorrichtung eine bewegliche Trägerkomponente mit dem wenigstens einen Magnetfeldsensor umfasst, wobei die Trägerkomponente zur vollständigen Vermessung der Messoberfläche sukzessive mittels einer Bewegungseinrichtung der Messvorrichtung an verschiedene Messpositionen bewegt wird. Hierbei kann die Messvorrichtung insbesondere auch eine Steuereinrichtung umfassen, welche die Bewegungseinrichtung und den wenigstens einen Magnetfeldsensor entsprechend ansteuern kann, um gewünschte Messpunkte anzufahren und Messungen vorzunehmen.

Dabei kann eine mit besonders wenigen Magnetfeldsensoren auskommende Lösung vorsehen, dass die Trägerkomponente genau einen Magnetfeldsensor umfasst und/oder die Bewegungseinrichtung ein Roboterarm ist. Die Steuereinrichtung kann den Roboterarm nun so ansteuern, dass der eine Magnetfeldsensor sukzessive an allen Messpunkten, die entsprechend vorausbestimmt sind, platziert wird. Für jeden Messpunkt werden Sensordaten erfasst, insbesondere die lokale Feldstärke des Magnetfelds und/oder die drei kartesischen Komponenten des Vektor-Magnetfelds. Eine derartige Ausgestaltung stellt maximale Flexibilität hinsichtlich der Zahl der Messpunkte, der Abtasttrajektorie und dergleichen bereit. Insbesondere kann die Abtastdichte variiert werden und/oder es können verschiedene Messoberflächen, beispielsweise Kugeln verschiedener Durchmesser, Ellipsoide und dergleichen, herangezogen werden. Problematisch kann sich bei einem derartigen Ausführungsbeispiel jedoch die lange Vermessungszeit, also Kalibrierungszeit, erweisen.

In einer besonders bevorzugten Ausgestaltung der vorliegenden Erfindung kann vorgesehen sein, dass die Trägerkomponente eine einen Teil der Messoberfläche abdeckende Trägerfläche, auf der die mehreren Magnetfeldsensoren gemäß den gleichverteilten Messpunkten gleichverteilt angeordnet sind, aufweist, wobei die Trägerfläche für die unterschiedlichen Messpositionen unterschiedliche Anteile der Messoberfläche derart abdeckt, dass jeder Messpunkt wenigstens einmal vermessen wird. Um die Vermessungszeit, insbesondere im Vergleich zur Verwendung nur eines einzigen Magnetfeldsensors, zu reduzieren, wird vorgeschlagen, mehrere Magnetfeldsensoren zu verwenden, die auf der Trägerkomponente eine Art "Trägerarray" bilden, der zumindest in der Lage der Magnetfeldsensoren einem Teil der Messoberfläche und den dortigen Messpunkten nachgebildet ist. Dieser Sensor-Array wird an verschiedenen Messpositionen derart angeordnet, dass letztendlich alle Messpunkte mit einer verkleinerten Zahl von Messschritten abgedeckt werden können. Hierzu sind die Magnetfeldsensoren entsprechend dem Abtastmuster auf der Trägerfläche, die als ein Abschnitt der Messoberfläche geformt ist, gleichverteilt angeordnet. An den verschiedenen Messpositionen bildet die Trägerfläche also immer wieder einen anderen Anteil der gesamten Messoberfläche, die über die Zeit nach den mehreren Messschritten dann vollständig abgedeckt ist und auch die Gleichverteilung der Messpunkte einhält, da die Anordnung der Magnetfeldsensoren gemäß dieser Gleichverteilung auf der Trägerfläche gewählt ist.

Beispielsweise kann im Fall einer Kugeloberfläche als Messoberfläche die Trägerkomponente als eine sphärische Kalotte ausgebildet sein, die als herausgeschnittener Anteil einer virtuellen Messsphäre verstanden werden kann und auf der die Magnetfeldsensoren gleichverteilt gemäß dem Abtastmuster, welches dann beispielsweise nach dem Fibonacci-Kugel-Algorithmus bestimmt sein kann, angeordnet sind. Nachdem die Verteilung der Messpunkte gleichmäßig über die gesamte Kugeloberfläche als Messoberfläche ist, ist offensichtlich, dass die Messfläche von der Bewegungseinrichtung so positioniert werden kann (rotiert, gekippt und/oder verschoben), dass die Magnetfeldsensoren auf der Trägerkomponente in ihren Positionen mit Messpunkten übereinstimmen. Nachdem die Verteilung der Messpunkte der Steuereinrichtung bekannt ist, kann diese Aktoren der Bewegungseinrichtung entsprechend ansteuern, um in möglichst wenig Kalibrierungsschritten die Gesamtheit der Messpunkte anzufahren und entsprechend zu vermessen.

Eine besonders vorteilhafte Ausgestaltung ergibt sich dann, wenn die Form der Trägerfläche derart gewählt ist, dass sich eine natürliche Anzahl der Trägerflächen zu der vollständigen Messoberfläche, insbesondere Kugeloberfläche, zusammensetzt, wobei die Zahl der Messpositionen der natürlichen Zahl entspricht. Bei einem letztlich beliebigen Ausschnitt aus der Messoberfläche als Trägerfläche kann es auftreten, dass es Überlappe zwischen den abgedeckten Anteilen der Messoberfläche an verschiedenen Messpositionen geben kann. Dabei ist es in diesem Zusammenhang zwar denkbar, die Messgenauigkeit für doppelt vermessene Messpunkte zu erhöhen, indem eine Mittelung der entsprechenden Sensordaten stattfindet, jedoch kann die Messzeit minimiert werden, wenn solche Überlappe minimiert oder sogar vollkommen verhindert wird.

Erfindungsgemäß kann nun ausgenutzt werden, dass es im Stand der Technik aus der analytischen Geometrie bekannt ist, die Oberfläche einer Kugel in gleichartige, gebogene Trägerflächen zu zerlegen, die als polyedrische Oberflächen bekannt sind. Anders gesagt schlägt dieses besonders bevorzugte Ausführungsbeispiel mithin vor, dass die Trägerfläche bei einer Kugeloberfläche als Messoberfläche als eine polyedrische Oberfläche (englisch polyhedral surface) ausgebildet ist. Der Prozess zum Erhalt polyedrischer Flächen wird auch als Kugelzerlegung (Kugeltesselation) bezeichnet, wobei rein beispielhaft auf den Artikel "Dividing a sphere into equal-area and/or equilateral spherical polygons" von Anooshe Rezaee Javan et al., Journal of Computational Design and Engineering, 9 (2022), Pages 826 - 836, verwiesen sei. Es sei darauf hingewiesen, dass bereits die gleichförmige Verteilung der Messpunkte über die Messoberfläche einer Kalibrierungssphäre eine solche Zerlegung erzeugt, nachdem diese beispielsweise in der Gruppe von vier benachbarten Messpunkten eine tetraedische Form bildet, wobei diese tetraedischen Formen als gekurvtes Mosaik die gesamte Kugeloberfläche bilden. Bei einer solchen Wahl der Trägerfläche ist es ausreichend, genau so viele Messpositionen zu verwenden, wie Trägerflächen notwendig sind, um lückenlos die gesamte Messoberfläche zu bilden.

Die Trägerfläche muss, allgemein gesprochen, nicht zwangsläufig gebogen ausgebildet sein, sondern kann auch eben gewählt werden. Beispielsweise ist es denkbar, durch einen Polyeder eine Kugeloberfläche anzunähern oder die Messoberfläche unmittelbar polyedrisch zu wählen. Besonders bieten sich hier platonische Körper oder angenähert platonische Körper an, die aus kongruenten Begrenzungsflächen zusammengesetzt sind. Wird dann beispielsweise eine solche Begrenzungsfläche als Trägerfläche gewählt, ergibt sich die Zusammensetzbarkeit aus einer natürlichen Zahl der Trägerflächen automatisch. Beispielsweise kann eine Messoberfläche also als Oberfläche eines Dodekaeders oder eines Ikosaeders gebildet werden. Auch andere Näherungen oder Konstruktionen mit ebenen Trägerflächen sind denkbar.

Konkrete Ausgestaltungen der Bewegungseinrichtung werden im Folgenden bezüglich der erfindungsgemäßen Messvorrichtung genauer beschrieben. Dabei sei bereits an dieser Stelle angemerkt, dass sich sämtliche Ausführungen zum erfindungsgemäßen Verfahren analog auf die erfindungsgemäße Messvorrichtung übertragen lassen und auch umgekehrt. Auf diese Weise können mit der erfindungsgemäßen Messvorrichtung insbesondere auch die Vorteile erreicht werden, die sich durch das erfindungsgemäße Verfahren ergeben und umgekehrt.

Eine erfindungsgemäße Messvorrichtung zur Vermessung eines Magnetfelds in einem Sichtfeld einer Magnetresonanzeinrichtung weist eine bewegliche Trägerkomponente mit wenigstens einem Magnetfeldsensor, eine Bewegungseinrichtung zum Bewegen der Trägerkomponente und eine Steuereinrichtung auf, wobei die Steuereinrichtung zur Messung von das Magnetfeld beschreibenden Sensordaten durch gleichmäßige Abtastung der gesamten Messoberfläche an mehreren Messpunkten in einem gleichverteilten Abtastmuster auf einer wenigstens einen Teil des Sichtfelds umschließenden Messoberfläche durch Ansteuerung der Bewegungseinrichtung und des wenigstens einen Magnetfeldsensors ausgebildet ist. Die Steuereinrichtung kann ferner auch zum Ermitteln einer Magnetfeldinformation, die das Magnetfeld wenigstens innerhalb des Sichtfelds dreidimensional modelliert, aus den Sensordaten ausgebildet sein.

Dabei sei an dieser Stelle noch sowohl für das Verfahren als auch für die Messvorrichtung angemerkt, dass die erhaltene Magnetfeldinformation zu verschiedenen Zwecken weiterverwendet werden kann, beispielsweise zur Auswahl und/oder zum Parametrieren von Korrekturmaßnahmen verwendet werden und/oder als Kalibrierungsinformation, die für Magnetresonanzsequenzen und/oder Aufnahmeprotokolle bei der Rekonstruktion von Magnetresonanzbildern und/oder sonstigen Bildgebungsergebnissen zu verwenden ist, gespeichert werden.

Wie bereits diskutiert, ist es zum einen möglich, dass die Trägerkomponente nur einen einzigen Magnetfeldsensor umfasst und die Bewegungseinrichtung ein Roboterarm ist, was eine große Flexibilität ermöglicht, jedoch bei einer großen Anzahl von Messpunkten eine lange Gesamtmesszeit zur Folge haben kann. Bevorzugt ist es demgegenüber, wie beschrieben, wenn die Trägerkomponente eine einen Teil der Messoberfläche abdeckende Trägerfläche, auf der die mehreren Magnetfeldsensoren gemäß den gleichverteilten Messpunkten gleichverteilt angeordnet sind, aufweist. Hierbei kann die Trägerfläche für unterschiedliche Messpositionen unterschiedliche Anteile der Messoberfläche derart abdecken, dass jeder Messpunkt wenigstens einmal vermessen wird. Mit besonderem Vorteil kann dabei vorgesehen sein, dass die Form der Trägerfläche derart gewählt ist, dass sich eine natürliche Zahl der Trägerflächen zu der vollständigen Messoberfläche, insbesondere Kugeloberfläche, zusammensetzt. Die Zahl der Messpositionen kann dann der natürlichen Zahl entsprechen.

Besonders zweckmäßig ist es bezüglich der Messvorrichtung dann, wenn die Messoberfläche eine Kugeloberfläche ist, wenn die Bewegungseinrichtung wenigstens zwei Rotationsaktoren zur Rotation um zueinander senkrechte Rotationsachsen zur beliebigen Positionierung der Trägerfläche auf der Messoberfläche aufweist. Beispielsweise kann sich ein erster Rotationsaktor auf eine horizontale Rotationsachse beziehen. Der zweite Rotationsaktor wird durch den ersten Rotationsaktor gedreht und betrifft den verbleibenden Freiheitsgrad auf der Kugeloberfläche. Beispielsweise kann die Messvorrichtung dann zur Vermessung des Magnetfelds so positioniert werden, dass der Schnittpunkt der ersten Rotationsachse und der zweiten Rotationsachse im Isozentrum des Sichtfelds zum Liegen kommen. Nun sind nur noch zwei Rotationsfreiheitsgrade zur Positionierung der Trägerfläche an der gewünschten Messposition auf der Kugeloberfläche notwendig, die durch die beiden Rotationsaktoren bereitgestellt werden.

Um sicherzustellen, dass die Magnetfeldsensoren auch an den entsprechenden Messpunkten zum Liegen kommen, kann zusätzlich eine Drehung der Trägerfläche an sich, beispielsweise um deren Mittelpunkt, notwendig sein. In diesem Zusammenhang kann die Erfindung bevorzugt vorsehen, dass die Belegungseinrichtung einen weiteren Aktor zur Rotation der mehrere Magnetfeldsensoren aufweisenden Trägerfläche um sich selbst aufweist, insbesondere um eine durch den Mittelpunkt der Drehfläche verlaufende Rotationsachse. Auch diese Rotationsachse kann durch das Isozentrum des Sichtfelds verlaufen.

In einer ersten vorteilhaften, konkreten Ausgestaltung kann vorgesehen sein, dass die Bewegungseinrichtung einen mittels des ersten Rotationsaktors um eine horizontale Rotationsachse rotierbaren Kreisbogenarm aufweist, an den über einen mittels des zweiten Rotationsaktors verschiebbaren Führungsschlitten die Trägerkomponente angekoppelt ist. Der über den ersten Rotationsaktor drehbare Kreisbogenarm bildet in seinem Kreisbogenanteil mithin gleichzeitig die Führung für einen Führungsschlitten, an den die Trägerkomponente angeordnet ist, so dass durch Verschiebung des Führungsschlittens auf dem Kreisbogenarm durch den zweiten Rotationsaktor eine Drehung der Trägerfläche um die zweite Rotationsachse erfolgen kann. Beispielsweise kann der Führungsschlitten den Kreisbogenarm umgreifen und/oder in den Kreisbogenarm eingreifen, wo dann beispielsweise auch der zweite Rotationsaktor, beispielsweise als Motor, angeordnet sein kann. Der Kreisbogenarm kann sich beispielsweise über einen Winkelbereich von wenigstens 180° erstrecken, so dass beispielsweise eine Verstellung um +/-90° möglich ist. Selbstverständlich kann der Kreisbogenarm auch erweitert sein, beispielsweise bis hin zu einem vollständigen Kreis. In einem solchen Fall kann der Führungsschlitten eine Rotation von 360° um den Schnittpunkt der ersten oder zweiten Rotationsachse ermöglichen.

In einer weiteren, alternativen, konkreten Ausgestaltung kann vorgesehen sein, dass die Bewegungseinrichtung einen mittels des ersten Rotationsaktors um eine horizontale Rotationsache rotierbaren Rahmenarm aufweist, an dem, an einem von dem ersten Rotationsaktor abgewandten Ende entlang der horizontalen Rotationsachse, über den zweiten Rotationsaktor die Trägerkomponente angekoppelt ist, wobei der Rahmenarm entlang der ersten, horizontalen Rotationsachse einen wenigstens dem Durchmesser der Messoberfläche entsprechenden Freiraum zur Rotation der Trägerkomponente mittels des zweiten Rotationsaktors definiert. Gegenüber dem zuvor beschriebenen ersten Ausführungsbeispiel besteht dabei der Vorteil, dass die Länge von Kabeln für den zweiten Rotationsaktor und/oder den weiteren Aktor und/oder die Magnetfeldsensoren in dieser zweiten konkreten Ausführungsform für alle räumlichen Positionen der Trägerkomponente die gleiche Länge aufweisen. Hierbei bietet der Rahmenarm durch eine entsprechend umrahmte Lücke den Rotationsfreiraum für die Trägerkomponente mittels des zweiten Rotationsaktors. Es sind also keine dehnbaren Kabel oder Kabelrollen erforderlich, die mit variablen Kabellängen arbeiten. Obwohl der Rahmenarm grundsätzlich lediglich einen Halbrahmen definieren muss, kann es zweckmäßig sein, wenn dieser vollständig umlaufend, also als vollständiger Rahmen, ausgebildet ist, um die mechanische Stabilität während des Vermessungsvorgangs zu erhöhen.

Insgesamt sei noch angemerkt, dass die Messvorrichtung an verschiedenen Stellen eingesetzt werden kann. Während es grundsätzlich denkbar ist, eine Vermessung des Magnetfelds bei bereits fertig oder zumindest bezüglich der Magnetfeldkomponenten vollständig verbauter Magnetresonanzeinrichtung am Verbauort der Magnetresonanzeinrichtung vorzunehmen, kann die Messvorrichtung grundsätzlich auch bei der Herstellung bereits Verwendung finden. Beispielsweise kann die Messvorrichtung bereits zur Kalibrierung hinsichtlich des Hauptmagnetfelds in der Produktionslinie eingesetzt werden, bevor weitere Komponenten montiert werden. Auch ist es denkbar, die Messvorrichtung allein zur Kalibrierung wenigstens einer Gradientenspule einer Gradientenspulenanordnung, bevor diese verbaut wird, zu verwenden.

Dabei sei an dieser Stelle noch angemerkt, dass die Zahl der Messpunkte insbesondere wenigstens der Zahl der zu bestimmenden Koeffizienten entsprechen kann. Je nachdem, wie groß die erwartete Inhomogenität ist, können, allgemein gesprochen, viele Messpunkte erforderlich sein, beispielsweise wenigstens 300, insbesondere wenigstens 600, gegebenenfalls sogar wenigstens 900 Messpunkte.

Weitere Vorteile und Einzelheiten der vorliegenden Erfindung ergeben sich aus den im Folgenden beschriebenen Ausführungsbeispielen sowie anhand der Zeichnung. Dabei zeigen:

Fig. 1　einen Ablaufplan eines Ausführungsbeispiels des erfindungsgemäßen Verfahrens,

Fig. 2 eine Prinzipskizze eines Sichtfelds und eines erweiterten Sichtfelds in einer Magnetresonanzeinrichtung,

Fig. 3 eine Verteilung von Messpunkten auf einer Messoberfläche,

Fig. 4 eine Prinzipskizze einer erfindungsgemäßen Messvorrichtung gemäß einem ersten Ausführungsbeispiel,

Fig. 5 schematisch eine Trägerkomponente der Messvorrichtung,

Fig. 6 die Zerlegung einer Sphäre in polyedrische Oberflächen, und

Fig. 7 eine Prinzipskizze einer erfindungsgemäßen Messvorrichtung gemäß einem zweiten Ausführungsbeispiel.

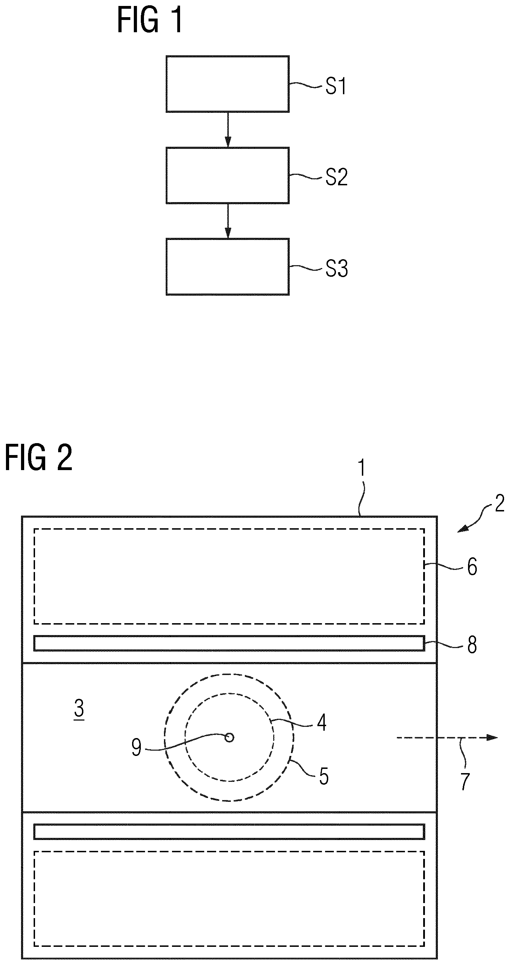

Fig. 1 zeigt einen Ablaufplan eines Ausführungsbeispiels des erfindungsgemäßen Verfahrens. Dabei soll vorliegend das Magnetfeld innerhalb des Sichtfelds einer Magnetresonanzeinrichtung vermessen werden, wozu in einem Schritt S1 zunächst eine Messvorrichtung geeignet zur Erfassung von Sensordaten des Magnetfelds platziert wird. Dabei zeigt Fig. 2 schematisch die durch eine Hauptmagneteinheit 1 der Magnetresonanzeinrichtung 2 definierte Patientenaufnahme 3 und mögliche Definitionen von Sichtfeldern 4, 5 darin. Die Hauptmagneteinheit 1 umfasst einen supraleitenden Hauptmagneten 6, der ein Hauptmagnetfeld (BO-Feld) erzeugt, das in der zylindrischen Patientenaufnahme in deren Längsrichtung 7 (z-Richtung) verläuft und in einem Homogenitätsvolumen in der Mitte der Patientenaufnahme 3 Anforderungen an die Homogenität erfüllt. Ferner gezeigt ist eine Gradientenspulenanordnung 8 zur Erzeugung von insbesondere der Ortskodierung dienenden Gradientenfeldern.

Das Sichtfeld 4 ist das Nenn-Sichtfeld der Magnetresonanzeinrichtung 2. Es ist vorliegend sphärisch ausgebildet und wurde so definiert, dass darin Anforderungen an die Homogenität des Hauptmagnetfelds genauso erfüllt sind wie Anforderungen an die Gradientenfelder, beispielsweise was deren Linearität angeht. Nichtsdestotrotz kann es innerhalb des Nenn-Sichtfelds 4 an dessen Rand, also entfernt vom Isozentrum 9, bereits zu Inhomogenitäten/größeren Abweichungen von der Linearität der Gradientenfelder kommen.

Beispielsweise bei größeren beziehungsweise fettleibigeren Patienten und/oder bei weit außenliegenden Aufnahmebereichen von Patienten kann es wünschenswert sein, ein gegenüber dem Nenn-Sichtfeld 4 erweitertes Sichtfeld 5 zu verwenden. In diesem sind die Anforderungen an das Hauptmagnetfeld und die Gradientenfelder nicht mehr erfüllt, jedoch können durch geeignete Rekonstruktionsmethoden Abweichungen von der Homogenität bei der Rekonstruktion berücksichtigt werden. Dies kann eine Anwendung der mit dem erfindungsgemäßen Verfahren ermittelten Magnetfeldinformation sein. Hat das Nenn-Sichtfeld 4 beispielsweise einen Durchmesser von 50 cm, kann das erweiterte Sichtfeld 5 beispielsweise einen Durchmesser von 70 cm haben.

Grundsätzlich kann das zu vermessende Magnetfeld das Hauptmagnetfeld und/oder das Gradientenfeld umfassen. Es sei angemerkt, dass eine alleinige Vermessung des Gradientenfelds beispielsweise in der Produktionslinie vor Einbau der Gradientenspulenanordnung 8 in die Hauptmagneteinheit 1 erfolgen kann. Im vorliegenden Beispiel wird im erweiterten Sichtfeld 5 eine Vermessung sowohl des Hauptmagnetfelds als auch der Gradientenfelder angestrebt, gegebenenfalls in mehreren aufeinanderfolgenden Messvorgängen.

Ziel der Vermessung ist es, ein Magnetfeldmodell der Magnetfeldinformation zu parametrieren. Vorliegend wird das Magnetfeld in einer Zerlegung nach harmonischen Funktionen, insbesondere nach Solid Harmonics, modelliert, das bedeutet, als eine Summe verschiedener harmonischer Funktionen als Basisfunktionen dargestellt, wobei die jeweiligen Koeffizienten die Gewichtung in der Summe angeben. Daher soll das Magnetfeld mittels der Messvorrichtung vorliegend an Messpunkten gemessen werden, die auf einer als Kugeloberfläche einer virtuellen Messkugel beziehungsweise Kalibrierungskugel ausgebildeten Messoberfläche liegen. Die Messoberfläche kann dabei vorliegend als die Oberfläche des sphärischen jeweiligen Sichtfelds 4, 5, im Beispiel des erweiterten Sichtfelds 5, gewählt werden.

Zurückkehrend zu Fig. 1 werden daher in einem Schritt S2 Sensordaten mit dem wenigstens einen Magnetfeldsensor der Messvorrichtung an Messpunkten auf der Messoberfläche aufgenommen. Nachdem im erweiterten Sichtfeld 5 gemessen wird, ist mit starken Inhomogenitäten zu rechnen, so dass eine Vielzahl von harmonischen Funktionen, hier Solid Harmonics, als Basisfunktionen berücksichtigt werden müssen und entsprechend viele Koeffizienten in dem folgenden Schritt S3 bei der Auswertung der Sensordaten bestimmt werden. Dies fordert nicht nur eine hohe Zahl von Messpunkten auf der Messoberfläche, sondern, nachdem sowohl zonale auch als sektorale und tesserale Muster auf der Messoberfläche auftreten können, auch eine geschickte Wahl der Messpunkte.

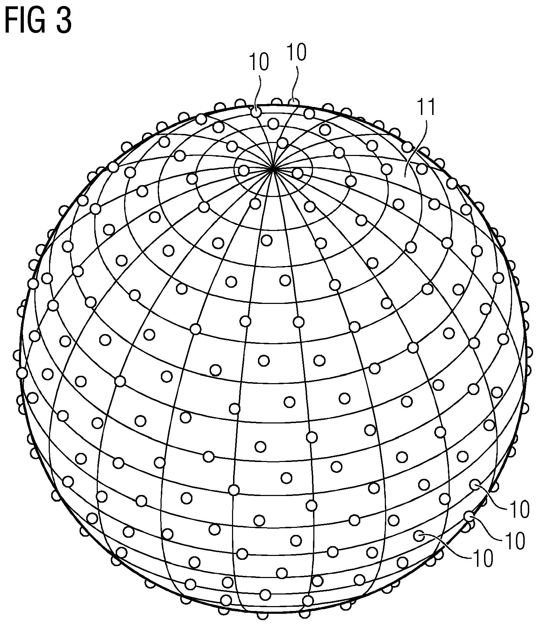

Im erfindungsgemäßen Verfahren werden die Messpunkte so gewählt, dass sich eine Gleichverteilung, mithin ein gleichmäßiges Abtastmuster, für die gesamte Messoberfläche ergibt. Dies ist beispielhaft für 360 Messpunkte 10 auf einer als Kugeloberfläche ausgebildeten Messoberfläche 11 in Fig. 3 gezeigt. Die dort gezeigten Messpunkte wurden mit dem Fibonacci-Kugel-Algorithmus, also als Fibonacci-Gitter, auf der Messoberfläche 11 bestimmt.

Die Messvorrichtung ist dazu ausgebildet, die Messungen sukzessive über mehrere Messpositionen einer den wenigstens einen Magnetfeldsensor tragenden Trägerkomponente, also in verschiedenen Kalibrierungsschritten vorzunehmen. Während es grundsätzlich denkbar ist, in einer flexiblen Ausgestaltung einer Messvorrichtung einen einzigen Magnetfeldsensor an einem Roboterarm als Bewegungseinrichtung anzuordnen, ist es erfindungsgemäß bevorzugt, zur Reduzierung der Gesamtmesszeit mehrere Magnetfeldsensoren auf einer Trägerfläche der Trägerkomponente vorzusehen, um mehrere Messpunkte 10 gleichzeitig an einer Messposition vermessen zu können.

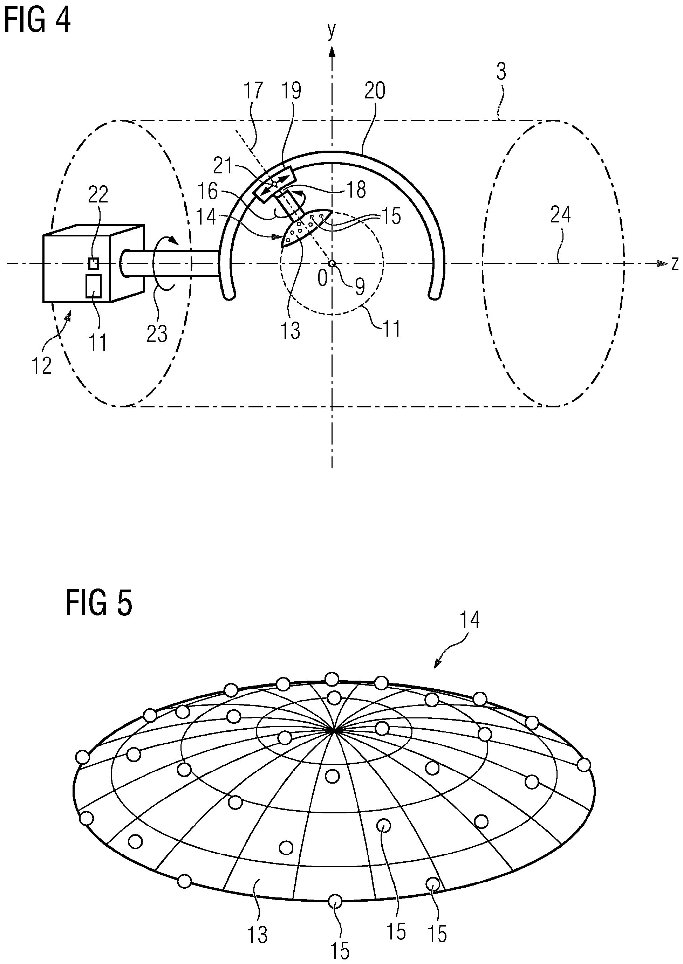

Entsprechende Ausgestaltungen von solchen Messvorrichtungen werden im Späteren im Hinblick auf die Figuren 4 bis 7 näher erläutert.

In jedem Fall entspricht die Trägerfläche, auf der die Magnetfeldsensoren angeordnet sind, in ihrem Verlauf einem Teil der Messoberfläche 11, wobei auf der Trägerfläche die Magnetfeldsensoren gemäß den Messpunkten 10, also dem gleichmäßigen Abtastmuster, angeordnet sind. Die Trägerfläche kann also als Ausschnitt aus der Messoberfläche 11 der Fig. 3 verstanden werden, wobei an den Messpunkten 10 des Ausschnitts Magnetfeldsensoren angeordnet sind. Dabei kann die Trägerfläche durch Kugeltesselation so bestimmt sein, dass sich eine natürliche Zahl von Trägerflächen überlappfrei und lückenfrei zu der gesamten Messoberfläche 11 ergänzt, so dass mit dieser natürlichen Zahl an Messpositionen alle Messpunkte 10 vermessen werden können. Kommt es in anderen Fällen zu Überlappen, können Sensordaten mehrfach vermessener Messpunkte 10 zur Erhöhung der Genauigkeit gemittelt werden. In anderen Ausführungsbeispielen kann eine Kugeloberfläche auch nur angenähert werden bzw. eine polyedrische Messoberfläche gewählt werden, wenn die Trägerfläche eben gewählt wird.

Im Schritt S3 werden dann durch Auswertung der Sensordaten die Koeffizienten der jeweiligen harmonischen Funktionen, hier Solid Harmonics, im Fit bestimmt. Nachdem die Abtastung im Schritt S2 aufgrund der geschickten Wahl der Messpunkte 10 bidirektional gleichförmig auf der Messoberfläche 11 erfolgt ist, ergibt sich die gewünschte Abtastdichte in allen Richtungen und das Magnetfeld kann trotz Inhomogenitäten hochqualitativ modelliert werden. Die Magnetfeldinformation kann zur Auswahl und/oder Parametrierung von Kompensationsmaßnahmen, beispielsweise Shimmaßnahmen, und/oder als Kalibrierungsinformation für die Rekonstruktion insbesondere außerhalb des Nenn-Sichtfelds 4, hinterlegt werden.

Fig. 4 zeigt ein erstes Ausführungsbeispiel einer erfindungsgemäßen Messvorrichtung 12, die gemäß Schritt S1 bereits so positioniert wurde, dass eine Messung auf der Messoberfläche 11 stattfinden kann, die sich um das Isozentrum 9 der Patientenaufnahme 3 erstreckt. Die Messvorrichtung 12 weist eine Mehrzahl von gleichverteilt auf einer Trägerfläche 13 einer Trägerkomponente 14 angeordneten Magnetfeldsensoren 15 auf. Die Trägerkomponente 14 ist gemäß dem Pfeil 16 um eine durch den Mittelpunkt der Trägerfläche 13 sowie das Isozentrum 9 verlaufende Rotationsachse 17 drehbar. Hierzu dient ein Aktor 18, der die Trägerkomponente 14 an einen Führungsschlitten 19 koppelt, der auf einem Kreisbogenarm 20 geführt ist. Über einen Rotationsaktor 21 ist der Führungsschlitten 19 entlang des Kreisbogenarms 20 bewegbar und ermöglicht somit eine Rotation der Trägerkomponente 14 und somit der Trägerfläche 13 um eine in der gezeigten Stellung senkrecht zur Zeichenebene stehende, durch das Isozentrum 9 verlaufende Rotationsachse. Der Kreisbogenarm 20 wiederum ist mittels eines Rotationsaktors 22 gemäß dem Pfeil 23 um eine horizontale, ebenso durch das Isozentrum 9 verlaufende Rotationsachse 24 drehbar. Obwohl der Kreisbogenarm 20 in diesem Beispiel nur als einen Teil von 360° abdeckend gezeigt ist, kann dieser entsprechend erweitert werden, falls dies notwendig ist.

Mittels der Rotationsaktoren 22, 21 kann die Trägerfläche 13 an beliebige benötigte Messpositionen auf der Messoberfläche 11 verbracht werden. Mittels des weiteren Aktors 18 kann, falls notwendig, die Orientierung der Trägerfläche 13 so angepasst werden, dass die Magnetfeldsensoren 15 auch tatsächlich auf den gewollten Messpunkten 10, wie sie vorbestimmt und gewählt wurden, positioniert werden. Je nach Abtastdichte kann hier eine Rotierbarkeit gemäß dem Pfeil 16 um 180°, 90° oder sogar nur 10° ausreichend sein.

Die Messvorrichtung 12 weist ferner eine Steuereinrichtung 25 auf, die den Messbetrieb steuert, insbesondere durch Ansteuerung der Aktoren 22, 21, 18 zur Einstellung von Messpositionen und der Magnetfeldsensoren 15 zur Durchführung der Messungen.

Fig. 5 zeigt eine mögliche Ausgestaltung der Trägerkomponente 14 als Kugel-Kalotte, deren Trägerfläche 13 eine der Messoberfläche 11 entsprechende Wölbung aufweist, wobei sich an den entsprechenden Messpunkten 10 des Ausschnitts die Magnetfeldsensoren 15 befinden.

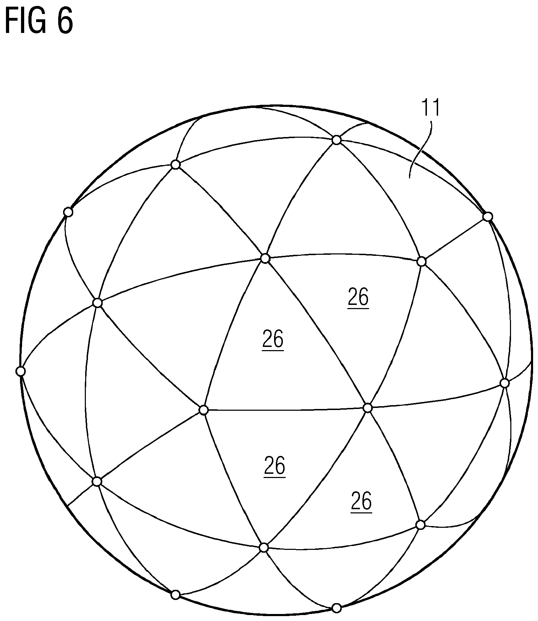

Fig. 6 zeigt beispielhaft eine Kugeltesselation für eine Messoberfläche 11, die in gleiche Ausschnitte 26, konkret polyedrische Oberflächen, zerlegt ist. Wird eine solche polyedrische Fläche für die Trägerfläche 13 gewählt, können ohne Überlapp alle Messpunkte 10 zeiteffizient an entsprechenden Messpositionen angefahren und vermessen werden.

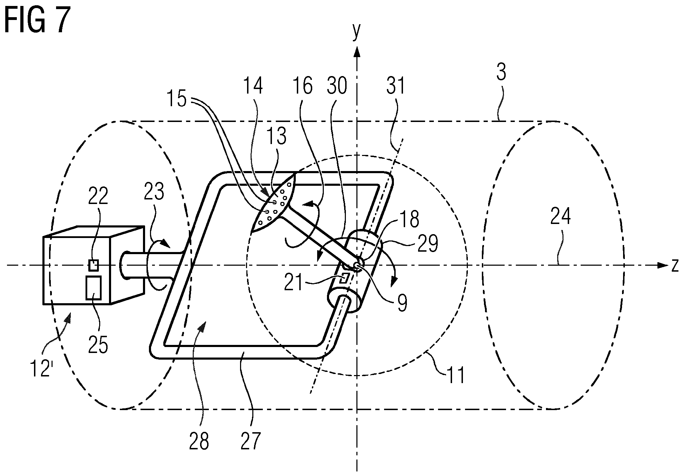

Fig. 7 zeigt ein zweites Ausführungsbeispiel einer erfindungsgemäßen Messvorrichtung 12', wobei der Einfachheit halber sich entsprechende Bestandteile mit den gleichen Bezugszeichen versehen sind. Dabei entspricht die Trägerkomponente 14 mit der Trägerfläche 13 und den Magnetfeldsensoren 15 sowie der Aktor 18 den Ausführungen zum ersten Ausführungsbeispiel. Dies gilt auch für den Rotationsaktor 22. Dieser rotiert nun allerdings einen Rahmenarm 27 um die horizontale Rotationsachse 24, der einen Freiraum 28 definiert. Durch diesen kann die Trägerkomponente 14 mittels des hier nur angedeuteten Rotationsaktors 21 gedreht werden. Denn die Trägerkomponente ist auf der dem Rotationsaktor 22 abgewandten Seite über ein Drehgelenk 29 angelenkt. Die wird mittels des Rotationsaktors 21 gemäß dem Pfeil 30 eine Drehung um die ebenso durch das Isozentrum verlaufende Rotationsachse 31 erreicht.

Dadurch, dass der Rahmenarm 27 einen kompletten Rahmen bildet, ist eine hohe mechanische Stabilität gegeben.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

**Patentansprüche**

1. Verfahren zur Vermessung eines Magnetfelds in einem Sichtfeld (4, 5) einer Magnetresonanzeinrichtung (2), aufweisend folgende Schritte:

   - Bereitstellen einer wenigstens einen Magnetfeldsensor (15) umfassenden Messvorrichtung (12, 12'),
   - Messen von das Magnetfeld beschreibenden Sensordaten an mehreren Messpunkten (10) auf einer wenigstens einen Teil des Sichtfelds (4, 5) umschließenden Messoberfläche (11), und
   - Ermitteln einer Magnetfeldinformation, die das Magnetfeld wenigstens innerhalb des Sichtfelds (4, 5) dreidimensional modelliert, aus den Sensordaten,

   **dadurch gekennzeichnet, dass** die Messpunkte (10) in einem gleichverteilten Abtastmuster zur gleichmäßigen Abtastung der gesamten Messoberfläche (11) gewählt werden.

2. Verfahren nach Anspruch 1, **dadurch gekennzeichnet, dass** die Messoberfläche (11) eine Kugeloberfläche ist und zur Ermittlung der Magnetfeldinformation Koeffizienten einer Entwicklung nach harmonischen Funktionen, insbesondere nach Solid Harmonics, ermittelt werden.

3. Verfahren nach Anspruch 1 oder 2, **dadurch gekennzeichnet, dass** das Sichtfeld (5) größer als ein Nenn-Sichtfeld (4) der Magnetresonanzeinrichtung (2) und/oder mit einem Durchmesser größer als 40 cm, insbesondere im Bereich von 50 bis 70 cm, gewählt wird.

4. Verfahren nach einem der vorangehenden Ansprüche, **dadurch gekennzeichnet, dass** das Magnetfeld ein Hauptmagnetfeld eines Hauptmagneten (6) der Magnetresonanzeinrichtung (2) und/oder wenigstens ein Gradientenfeld einer Gradientenspulenanordnung (8) der Magnetresonanzeinrichtung (2) umfasst.

5. Verfahren nach einem der vorangehenden Ansprüche, **dadurch gekennzeichnet, dass** die Messpunkte (10) auf der als Kugeloberfläche ausgebildeten Messoberfläche (11) nach einem Fibonacci-Kugel-Algorithmus als Fibonacci-Gitter bestimmt werden.

6. Verfahren nach einem der vorangehenden Ansprüche, **dadurch gekennzeichnet, dass** die Messvorrichtung (12, 12') eine bewegliche Trägerkomponente (14) mit dem wenigstens einen Magnetfeldsensor (15) umfasst, wobei die Trägerkomponente (14) zur vollständigen Vermessung der Messoberfläche (11) sukzessive mittels einer Bewegungseinrichtung der Messvorrichtung (12, 12') an verschiedene Messpositionen bewegt wird.

7. Verfahren nach Anspruch 6, **dadurch gekennzeichnet, dass** die Trägerkomponente (14) eine einen Teil der Messoberfläche (11) abdeckende Trägerfläche (13), auf der die mehreren Magnetfeldsensoren (15) gemäß den gleichverteilten Messpunkten (10) gleichverteilt angeordnet sind, aufweist, wobei die Trägerfläche (13) für die unterschiedlichen Messpositionen unterschiedliche Anteile der Messoberfläche (11) derart abdeckt, dass jeder Messpunkt (10) wenigstens einmal vermessen wird.

8. Verfahren nach Anspruch 7, **dadurch gekennzeichnet, dass** die Form der Trägerfläche (13) derart gewählt ist, dass sich eine natürliche Zahl der Trägerflächen (13) zu der vollständigen Messoberfläche (11), insbesondere Kugeloberfläche, zusammensetzt, wobei die Zahl der Messpositionen der natürlichen Zahl entspricht.

9. Messvorrichtung (12, 12') zur Vermessung eines Magnetfelds in einem Sichtfeld (4, 5) einer Magnetresonanzeinrichtung (2), aufweisend eine bewegliche Trägerkomponente (14) mit wenigstens einem Magnetfeldsensor (15), eine Bewegungseinrichtung zur Bewegung der Trägerkomponente (14) und eine Steuereinrichtung (25), wobei die Steuereinrichtung (25) zur Messung von das Magnetfeld beschreibenden Sensordaten durch gleichmäßige Abtastung einer wenigstens einen Teil des Sichtfelds (4, 5) umschließenden Messoberfläche (11) an mehreren Messpunkten (10) in einem gleichverteilten Abtastmuster auf der gesamten Messoberfläche (11) durch Ansteuerung der Bewegungseinrichtung und des wenigstens einen Magnetfeldsensors (15) ausgebildet ist.

10. Messvorrichtung nach Anspruch 9, **dadurch gekennzeichnet, dass** die Trägerkomponente (14) eine einen Teil der Messoberfläche (11) abdeckende Trägerfläche (13), auf der die mehreren Magnetfeldsensoren (15) gemäß den gleichverteilten Messpunkten (10) gleichverteilt angeordnet sind, aufweist.

11. Messvorrichtung nach Anspruch 10, **dadurch gekennzeichnet, dass** die Form der Trägerfläche (13) derart gewählt ist, dass sich eine natürliche Zahl der Trägerflächen (13) zu der vollständigen Messoberfläche (11), insbesondere Kugeloberfläche, zusammensetzt.

12. Messvorrichtung nach einem der Ansprüche 10 oder 11, **dadurch gekennzeichnet, dass** die Messoberfläche (11) eine Kugeloberfläche ist und die Bewegungseinrichtung wenigstens zwei Rotationsaktoren (21, 22) zur Rotation um zueinander senkrechte Rotationsachsen (24, 31) zur beliebigen Positionierung der Trägerfläche (13) auf der Messoberfläche (11) aufweist.

13. Messvorrichtung nach Anspruch 12, **dadurch gekennzeichnet, dass** die Bewegungseinrichtung einen weiteren Aktor (18) zur Rotation der mehrere Magnetfeldsensoren (15) aufweisenden Trägerfläche (13) um sich selbst aufweist, insbesondere eine durch den Mittelpunkt der Drehfläche verlaufende Rotationsachse (17).

14. Messvorrichtung nach Anspruch 12 oder 13, **dadurch gekennzeichnet, dass** die Bewegungseinrichtung einen mittels des ersten Rotationsaktors (22) um eine horizontale Rotationsachse (24) rotierbaren Kreisbogenarm (20) aufweist, an den über einen mittels des zweiten Rotationsaktors (21) verschiebbaren Führungsschlitten (19) die Trägerkomponente (14) angekoppelt ist.

15. Messvorrichtung nach Anspruch 12 oder 13, **dadurch gekennzeichnet, dass** die Bewegungseinrichtung einen mittels des ersten Rotationsaktors (22) um eine horizontale Rotationsachse (24) rotierbaren Rahmenarm (27) aufweist, an dem an einem von dem ersten Rotationsaktor (22) abgewandten Ende entlang der horizontalen Rotationsachse (24) über den zweiten Rotationsaktor (21) die Trägerkomponente (14) angekoppelt ist, wobei der Rahmenarm (27) entlang der horizontalen Rotationsachse (24) einen wenigstens dem Durchmesser der Messoberfläche (11) entsprechenden Freiraum (28) zur Rotation der Trägerkomponente (14) mittels des zweiten Rotationsaktors (21) definiert.

# FIG 1

# FIG 2

FIG 3

FIG 4

FIG 5

# FIG 6

EP 4 407 334 A1

FIG 7

17

Europäisches Patentamt
European Patent Office
Office européen des brevets

# EUROPÄISCHER RECHERCHENBERICHT

**Nummer der Anmeldung**

EP 23 15 3270

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | Anonym: "MFC-3045 Magnetic Field Camera User's Manual", Online , 2004, XP093053729, Internet Gefunden im Internet: URL:https://www.metrolab.com/wp-content/uploads/2015/07/MFC3045_manual_v30_rev10.pdf [gefunden am 2023-06-13] | 1,3,4, 6-11 | INV. G01R33/24 |
| Y | * Anhang 9; | 2 | |
| A | Seite 8; Abbildungen 8,9 * | 5,12-15 | |
| | ----- | | |
| X | WO 2014/097056 A1 (KONINKL PHILIPS NV [NL]; PHILIPS DEUTSCHLAND GMBH [DE]) 26. Juni 2014 (2014-06-26) | 1,4,9 | |
| Y | * Seite 13, Zeile 27 - Zeile 30; Abbildung 3 * | 2 | |
| A | * Seite 3, Absatz 1 * | 5,7,8, 12-15 | |
| | ----- | | |
| X | US 5 635 839 A (SRIVASTAVA VISHNU C [US] ET AL) 3. Juni 1997 (1997-06-03) * Spalte 4, Zeile 10 - Zeile 20 * | 1,4,6, 9-11 | RECHERCHIERTE SACHGEBIETE (IPC) |
| | ----- | | G01R |
| A | US 2022/404446 A1 (POPESCU STEFAN [DE]) 22. Dezember 2022 (2022-12-22) * das ganze Dokument * | 1-15 | |
| | ----- | | |
| A,D | US 5 313 164 A (STAREWICZ PIOTR M [US] ET AL) 17. Mai 1994 (1994-05-17) * das ganze Dokument * | 1,9 | |
| | ----- | | |
| | -/-- | | |

Der vorliegende Recherchenbericht wurde für alle Patentansprüche erstellt

| Recherchenort | Abschlußdatum der Recherche | Prüfer |
|---|---|---|
| München | 13. Juni 2023 | Skalla, Jörg |

EPO FORM 1503 03.82 (P04C03)

Seite 1 von 2

**EUROPÄISCHER RECHERCHENBERICHT**

Nummer der Anmeldung

EP 23 15 3270

**EINSCHLÄGIGE DOKUMENTE**

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | AITKEN A P ET AL: "Improved UTE-based attenuation correction for cranial PET-MR using dynamic magnetic field monitoring", MEDICAL PHYSICS, AIP, MELVILLE, NY, US, Bd. 41, Nr. 1, 17. Dezember 2013 (2013-12-17), XP012179790, ISSN: 0094-2405, DOI: 10.1118/1.4837315 [gefunden am 1901-01-01] * Abbildung 4 * ----- | 1,9 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 13. Juni 2023 | Skalla, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

Seite 2 von 2

**ANHANG ZUM EUROPÄISCHEN RECHERCHENBERICHT
ÜBER DIE EUROPÄISCHE PATENTANMELDUNG NR.**

EP 23 15 3270

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-06-2023

| Im Recherchenbericht angeführtes Patentdokument | Datum der Veröffentlichung | Mitglied(er) der Patentfamilie | | Datum der Veröffentlichung |
|---|---|---|---|---|
| WO 2014097056 A1 | 26-06-2014 | CN | 104903740 A | 09-09-2015 |
| | | EP | 2936182 A1 | 28-10-2015 |
| | | JP | 6719902 B2 | 08-07-2020 |
| | | JP | 2015536792 A | 24-12-2015 |
| | | US | 2015338475 A1 | 26-11-2015 |
| | | WO | 2014097056 A1 | 26-06-2014 |
| US 5635839 A | 03-06-1997 | DE | 69529327 T2 | 09-10-2003 |
| | | EP | 0710851 A1 | 08-05-1996 |
| | | JP | 3702514 B2 | 05-10-2005 |
| | | JP | H08224220 A | 03-09-1996 |
| | | US | 5635839 A | 03-06-1997 |
| US 2022404446 A1 | 22-12-2022 | EP | 4105671 A1 | 21-12-2022 |
| | | US | 2022404446 A1 | 22-12-2022 |
| US 5313164 A | 17-05-1994 | KEINE | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 10018690 B2
- US 5313164 A
- US 20220252685 A1
- US 10768257 B2

**In der Beschreibung aufgeführte Nicht-Patentliteratur**

- **ANOOSHE REZAEE JAVAN et al.** Dividing a sphere into equal-area and/or equilateral spherical polygons. *Journal of Computational Design and Engineering,* 2022, vol. 9, 826-836